# FASCICULE DE BREVET EUROPEEN

(11) **EP 4 324 311 B1**
(45) Date de publication et mention de la délivrance du brevet: **04.11.2026**
(21) Numéro de dépôt: 22717390.3
(22) Date de dépôt: 24.03.2022
(51) Int. Cl.: H05K 7/20

(54) **DISPOSITIF ELECTRONIQUE MODULAIRE A REFROIDISSEMENT OPTIMISE**
MODULARE ELEKTRONISCHE VORRICHTUNG MIT OPTIMIERTER KÜHLUNG
MODULAR ELECTRONIC DEVICE WITH OPTIMIZED COOLING

(30) Priorité: 16.04.2021 FR 2103941
(43) Date de publication de la demande: 21.02.2024
(73) Titulaire: Kontron Modular Computers SAS, 83078 Toulon Cedex 9 (FR)
(72) Inventeur: TISSOT, Serge, 83078 TOULON Cedex 9 (FR)
(74) Mandataire: Atout PI Laplace
(86) Numéro de dépôt international: PCT/EP2022/057731
(87) Numéro de publication internationale: WO 2022/218668

(56) Documents cités:
- JP-A- 2005 150 539
- US-A1- 2011 304 981
- US-A1- 2018 011 522

## Description

La présente invention se situe dans le domaine du refroidissement des cartes électroniques, et plus particulièrement dans le domaine des dispositifs électroniques modulaires. L'invention se rapporte à un dispositif électronique modulaire comprenant une carte électronique à refroidissement optimisé du ou des composants qu'elle porte. Dans un système électronique modulaire, une ou plusieurs cartes, identiques ou non, peuvent être connectées à l'aide d'une carte fond de panier, généralement passive.

Le ou les composants sont typiquement montés sur une carte de circuit imprimé, ou carte électronique, qui permet de les lier électriquement. En outre, la carte électronique agit comme un support mécanique pour ces composants. Néanmoins, une carte électronique seule est inefficace pour le transfert thermique vers l'extérieur de la chaleur produite par ses composants. En effet, la carte électronique n'apporte pas de solution pertinente pour évacuer la chaleur générée par les composants.

Pour assurer le refroidissement d'une telle carte, plusieurs solutions de l'art antérieur existent. Par exemple, il est possible de fixer un drain thermique sur tout ou une partie de la carte électronique, de façon à évacuer la chaleur produite par la carte vers l'extérieur comme le châssis dans lequel la carte électronique peut être encastrée.

Toute carte électronique comprend des points ayant une température plus élevée que le reste de la carte. Ces points chauds correspondent aux endroits où se trouvent certains composants qui délivrent de la chaleur, par exemple des processeurs. Pour améliorer l'évacuation de la chaleur de ces points chauds, il est possible d'utiliser des caloducs. Ces derniers sont de longs cylindres métalliques (par exemple en cuivre ou en aluminium) renfermant un fluide tel que de l'eau. Cette eau se trouve en équilibre entre sa phase gazeuse et sa phase liquide, en absence de tout autre gaz. Dans la portion du caloduc se situant près du composant à refroidir, l'eau chauffe et se vaporise en emmagasinant de l'énergie provenant de la chaleur émise par ce composant. Ce gaz remonte alors le caloduc pour arriver près d'un système de refroidissement où il sera refroidi, jusqu'à ce qu'il se condense pour redevenir à nouveau un liquide, et céder de l'énergie à l'air ambiant sous forme de chaleur.

Dans un système modulaire, par exemple du type ordinateur modulaire, les méthodes de refroidissement traditionnelles pour les cartes informatiques modulaires comprennent un flux d'air soufflé en parallèle au fond de panier d'un côté de la carte à l'autre. D'autres techniques utilisent un drain thermique conducteur de chaleur pour atteindre les parois froides latérales équipées de panier à cartes avec glissières, ou guides-cartes, qui sont perpendiculaires au fond de panier, la paroi froide étant refroidie par d'autres moyens, par exemple un ventilateur disposé du côté extérieur du panier à cartes. Parfois, un liquide circule à l'intérieur d'un drain thermique sur la carte et se dirige vers un échangeur de chaleur après avoir traversé le fond de panier.

Dans un système modulaire, plusieurs cartes (par exemple une ou plusieurs cartes à processeur, une ou plusieurs cartes graphiques ou toute autre combinaison de cartes) sont généralement enfichées en parallèle dans un fond de panier qui interconnecte les cartes entre elles. Cela permet d'obtenir une grande performance de calcul pour un bloc d'alimentation et un seul châssis. Un tel système modulaire permet une grande modularité à la fois au niveau de la conception du système (par le choix des éléments à assembler), au niveau de la maintenance et au niveau de l'insertion de nouvelles technologies qui peut être rendue nécessaire par un besoin de performance accru ou par l'obsolescence de composants. En effet, au moment de la fabrication, il est possible de concevoir des cartes de dimensions prédéfinies que l'on peut venir insérer dans le système modulaire. Et par la suite, il est possible, du fait de la modularité du système, de venir changer les cartes, de les faire évoluer et/ou réparer, sans devoir démonter l'ensemble du système modulaire, ni le requalifier totalement.

Les composants chauds, par exemple les processeurs, délivrent beaucoup de chaleur par unité de temps, exprimée en watts, qu'il faut évacuer efficacement sous peine de faire monter plus encore leur température, et de dépasser leur température maximum autorisée de fonctionnement. Les connecteurs informatiques pour l'utilisateur sont éventuellement placés en face avant, et les connecteurs de communication inter cartes fond de panier, parallèlement du côté de la face arrière.

Dans les solutions de l'art antérieur dites à refroidissement direct par air, le flux d'air est soufflé en parallèle au fond de panier d'un côté de la carte à l'autre. Cette configuration n'est pas optimale puisqu'elle ne permet pas l'alignement horizontal serré de plusieurs systèmes modulaires côte-à-côte, basés sur des cartes horizontales, ni l'empilage vertical serré de plusieurs systèmes modulaires l'un sur l'autre, basés sur des cartes verticales. Dans les solutions de l'art antérieur, un autre sens de flux d'air est très pénalisant du fait du manque d'espace libre à l'intérieur des systèmes modulaires pour pouvoir y positionner des plateaux de ventilation (de type ventilateur), et faire subir éventuellement au flux d'air entrant et sortant un virage à 90°.

En outre, ces solutions dites à refroidissement direct par air conduisent à forcer l'air à passer dans un espace restreint en forme de fente de passage libre entre deux cartes : cela oblige à espacer davantage les cartes, à tenir compte de la hauteur et disposition des composants de chaque carte pour doser l'air approprié, et à utiliser une ventilation puissante pour vaincre les forces de frictions générées par la forme de fente du canal d'air lui-même partiellement obstrué. Cette ventilation puissante dans les fentes est alors source de bruits acoustiques, de surconsommation d'énergie, de surdimensionnement des courants d'alimentation et d'autoproduction de chaleur.

Une autre solution de l'art antérieur, dite de refroidissement par conduction, consiste à drainer par conduction les calories des points chauds de la carte vers un mur froid, situé de chaque côté de la carte, et qui sert également de glissière et de maintien à la carte. Le drain est serré contre le mur froid par un dispositif mécanique, après insertion de la carte, dans le but de maintenir la carte, mais aussi d'assurer une résistance thermique la plus faible possible vers le mur froid. Puis le mur froid est lui-même maintenu refroidi par ventilation de son côté externe ou par circulation d'un liquide caloporteur maintenu à basse température.

Même si la solution de l'art antérieur, dite à refroidissement par conduction, présente certains avantages comme le libre choix de la méthode de refroidissement des murs froids et la non circulation sur l'électronique des poussières et contaminants contenus dans l'air néfastes aux composants (brouillard salin, vapeurs de moteurs thermiques, ...), elle présente plusieurs inconvénients très significatifs comme l'augmentation de la masse liée aux murs froids et surtout la perte de performance thermique liée aux résistances de contact d'une part entre le drain et le mur froid, et d'autre part, entre le point chaud et le drain. L'origine de cette résistance thermique entre le point chaud et le drain est expliquée au paragraphe suivant.

Les solutions existantes, dites à refroidissement par conduction, présentent un inconvénient lié au dimensionnement et à ses tolérances. Le ou les composants chaud(s), par exemple un processeur, est soudé sur la carte ou verrouillé dans un support lui-même soudé sur la carte. Le point de soudure crée une incertitude sur la hauteur totale du composant et son parallélisme par rapport au plan de la carte. Cette incertitude est liée à l'état de la soudure qui peut varier d'un composant à l'autre. Cette incertitude vient s'ajouter à l'incertitude intrinsèque du composant avant son assemblage sur la carte, en termes de hauteur et de parallélisme. Dans les systèmes modulaires traditionnels à conduction thermique, il est impératif d'arriver pour le drain à une hauteur bien définie et une coplanarité parfaite pour assurer le bon verrouillage en force du drain de la carte dans la glissière rigide guide-cartes, verrouillage nécessaire pour la bonne conduction thermique drain-mur froid et pour la fixation du drain et de la carte face aux chocs et vibrations éventuels. Or, le drain thermique conducteur, pour atteindre les parois latérales du mur froid servant aussi de guide carte, souvent en cuivre ou aluminium, n'est pas très souple et ne permet pas de compenser l'incertitude de hauteur et parallélisme du composant chaud. Une solution connue est d'ajouter une interface thermique d'une certaine épaisseur sur la surface de contact du composant chaud pour compenser la hauteur et l'orientation exacte du composant chaud par rapport à celles de la glissière. Cependant l'ajout de cette interface thermique additionnelle est pénalisant pour la performance thermique du système modulaire.

Les documents JP 2005150539 A, US 2011/304981 A1 et US 2018/011522 A1 décrivent des solutions de l'art antérieur.

L'invention vise à pallier tout ou partie des problèmes cités plus haut en proposant un dispositif électronique modulaire permettant un refroidissement optimisé des composants chauds de la carte, tout en conservant l'aspect modulaire des éléments du système dans lequel le dispositif est intégré. En outre, le dispositif électronique modulaire est compatible avec les incertitudes sur la hauteur et le parallélisme du ou des composants, sans pénaliser la performance thermique du dispositif. L'absence de circulation d'air poussiéreux ou contaminant sur l'électronique peut également être garantie.

A cet effet, l'invention a pour objet un dispositif électronique modulaire comprenant :
- un châssis ;
- une première carte électronique reliée au châssis et portant au moins un premier composant destiné à délivrer de la chaleur, ladite première carte électronique s'étendant selon un premier plan ;
- une première pièce thermiquement conductrice disposée sur la première carte électronique sensiblement parallèlement au premier plan et s'étendant depuis le au moins un premier composant au-delà d'une extrémité de la première carte électronique selon une première direction principale ;
- un premier dispositif de refroidissement de la première carte électronique ;
- un panier à cartes solidaire du châssis et comprenant au moins une glissière guide-cartes ;

le dispositif électronique modulaire étant caractérisé en ce que le premier dispositif de refroidissement comprend :
   - une première section utile de passage d'air ;
   - une pluralité de premières ailettes thermiquement conductrices disposées à distance du au moins un premier composant, la pluralité de premières ailettes formant, entre deux ailettes adjacentes, au moins un premier canal de passage débouchant vers la première section utile de passage d'air,
et en ce que le dispositif électronique modulaire comprend une pièce mécanique ayant une extrémité insérée dans la au moins une glissière guide-cartes du panier à cartes, la pièce mécanique étant la première pièce thermiquement conductrice ou un drain thermique disposé sur la première carte électronique. Le premier dispositif de refroidissement étant placé à la périphérie de la première pièce thermiquement conductrice, au-delà de la première carte électronique.

Avantageusement, la première carte électronique comprend des connecteurs en face arrière, le dispositif électronique modulaire comprenant en outre un fond de panier comprenant des connecteurs aptes à coopérer avec les connecteurs en face arrière d'une première carte électronique, la section utile de passage d'air étant disposée entre le panier à cartes et le fond de panier.

Dans un mode de réalisation, le dispositif de refroidissement peut comprendre une plaque disposée de façon à fermer un ou plusieurs canaux de passage d'air.

Dans un autre mode de réalisation, le dispositif électronique modulaire selon l'invention comprend en outre :
- une deuxième carte électronique reliée au châssis et portant au moins un deuxième composant destiné à délivrer de la chaleur, ladite deuxième carte électronique s'étendant selon un deuxième plan sensiblement parallèle au premier plan ;
- une deuxième pièce thermiquement conductrice disposée sur la deuxième carte électronique sensiblement parallèlement au deuxième plan et s'étendant depuis le au moins un deuxième composant au-delà d'une extrémité de la deuxième carte électronique selon une troisième direction principale sensiblement parallèle à la première direction principale ;
- un deuxième dispositif de refroidissement de la deuxième carte électronique ;
ledit deuxième dispositif de refroidissement comprenant une pluralité de deuxièmes ailettes thermiquement conductrices disposées à distance du au moins un deuxième composant, la pluralité de deuxièmes ailettes formant, entre deux ailettes adjacentes, au moins un deuxième canal de passage débouchant vers une deuxième section utile de passage d'air.

Dans un autre mode de réalisation, une ailette de la pluralité de premières ailettes est disposée entre deux ailettes de la pluralité de deuxièmes ailettes, et la deuxième section utile de passage d'air est la première section utile de passage d'air.

Dans un autre mode de réalisation, chaque canal de passage forme une section de sortie et la surface de la section de sortie est sensiblement égale à la section utile de passage d'air qui lui fait face.

Avantageusement, la première et/ou deuxième section utile de passage d'air est formée par un générateur de flux d'air, préférentiellement un ventilateur relié au châssis, orienté de sorte à évacuer l'air des premiers/deuxièmes canaux de passage vers l'extérieur du dispositif électronique modulaire.

Avantageusement, chaque canal de passage formant une section de sortie, le dispositif de refroidissement comprend un joint d'étanchéité entre la section de sortie et la section utile de passage d'air.

L'invention concerne aussi un procédé d'assemblage d'un tel dispositif électronique modulaire, comprenant les étapes suivantes :
- Disposition du drain thermique sur la carte électronique, le drain thermique présentant un ajourement apte à recevoir le au moins un composant ;
- Fixation du drain thermique à la périphérie de la carte électronique ;
- Appui de la pièce thermiquement conductrice sur le au moins un premier composant sensiblement parallèlement au premier plan, sur le drain thermique ;
- Fixation de la pièce thermiquement conductrice avec la carte électronique, en des points situés en périphérie du au moins un premier composant ;
- Fixer l'ensemble formé par la carte électronique et le drain thermique au panier à cartes par insertion du drain thermique ou de la pièce thermiquement conductrice dans des glissières fixes du panier à cartes.

L'invention sera mieux comprise et d'autres avantages apparaîtront à la lecture de la description détaillée d'un mode de réalisation donné à titre d'exemple, description illustrée par le dessin joint dans lequel :
La figure 1 représente schématiquement le principe du refroidissement optimisé d'un dispositif électronique modulaire selon l'invention ;
La figure 2 représente schématiquement un mode de réalisation d'un dispositif électronique modulaire selon l'invention ;
La figure 3 représente schématiquement un autre mode de réalisation d'un dispositif électronique modulaire selon l'invention ;
La figure 4 représente schématiquement un autre mode de réalisation d'un dispositif électronique modulaire selon l'invention ;
La figure 5 représente schématiquement une portion du dispositif de refroidissement selon un autre mode de réalisation du dispositif électronique modulaire selon l'invention ;
La figure 6 représente un organigramme des étapes d'un procédé d'assemblage d'un dispositif électronique modulaire selon l'invention.

Par souci de clarté, les mêmes éléments porteront les mêmes repères dans les différentes figures. Pour une meilleure visibilité et dans un souci de compréhension accrue, les éléments ne sont pas toujours représentés à l'échelle. Dans ce qui suit, le positionnement sur/sous (par exemple sur ou sous la carte) ainsi que horizontal/vertical est à voir de façon relative, notamment par rapport au positionnement de la carte électronique et de son composant chaud. Par exemple, les cartes électroniques sont schématisées dans une position horizontale. On peut noter que les cartes, et tout le dispositif, peuvent être à la verticale en gardant la face avant devant.

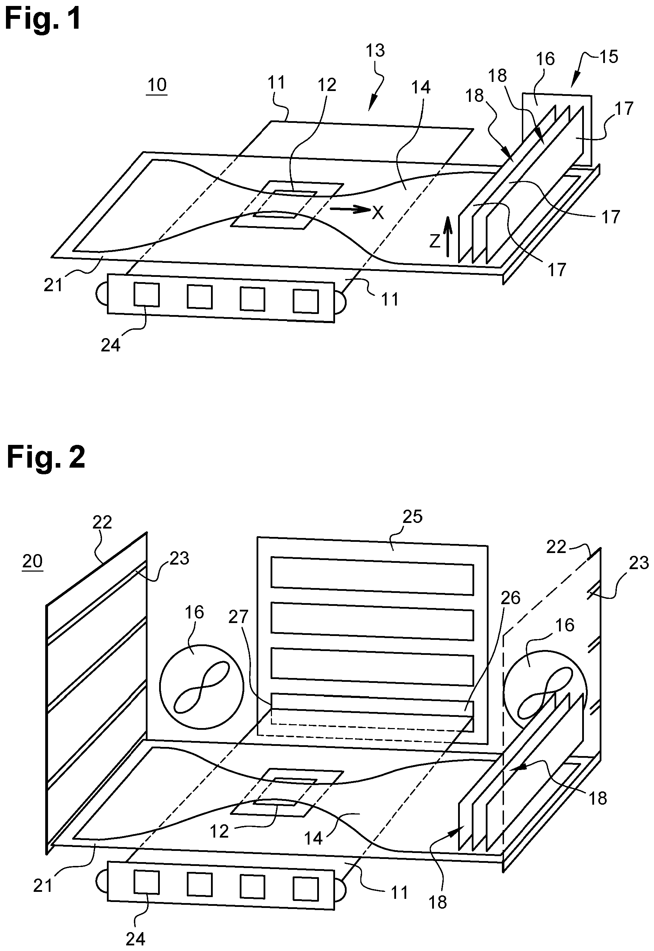

La figure 1 représente schématiquement le principe du refroidissement optimisé d'un dispositif électronique modulaire 10 selon l'invention. Le dispositif électronique modulaire 10 comprend un châssis (non représenté) et une première carte électronique 11 reliée au châssis. La première carte électronique 11 porte au moins un premier composant 12 délivrant de la chaleur (il peut s'agir par exemple d'un processeur ; en fonctionnement, le premier composant 12 délivre de la chaleur), ladite première carte électronique 11 s'étendant selon un premier plan 13. Le dispositif électronique modulaire 10 comprend une première pièce thermiquement conductrice 14 disposée sur la première carte électronique 11 sensiblement parallèlement au premier plan 13 et s'étendant depuis le au moins un premier composant 12 vers une extrémité, et au-delà de l'extrémité, de la première carte électronique 11 selon une première direction principale X. La première pièce thermiquement conductrice 14 peut être par exemple en cuivre ou en aluminium. Le dispositif électronique modulaire 10 comprend un premier dispositif de refroidissement 15 de la première carte électronique 11. Le premier dispositif de refroidissement 15 comprend une première section utile 16 de passage d'air, et une pluralité de premières ailettes 17 thermiquement conductrices disposées à distance du au moins un premier composant 12, la pluralité de premières ailettes 17 formant, entre deux ailettes adjacentes, au moins un premier canal de passage 18 débouchant vers la première section utile 16 de passage d'air.

Ainsi, la chaleur dégagée par le composant chaud 12 est transférée depuis le composant chaud à la pièce thermiquement conductrice 14 vers son extrémité selon la direction principale, et avantageusement selon des directions dans un couloir potentiellement évasé, vers les ailettes 17. Puis un transfert de chaleur opère depuis les ailettes 17 vers l'air circulant dans le ou les canaux de passage 18. Cet air chaud dans les canaux 18 est ensuite acheminé vers la première section utile 16 de passage d'air (du canal vers le fond), ou inversement (du canal vers l'avant) selon le type d'aération, au-delà de laquelle un mélange d'air s'opère entre l'air chaud issu des canaux 18 et l'air extérieur. La première section utile 16 d'air est obtenue grâce à un générateur de flux d'air apte à évacuer l'air chaud. De l'air frais rentre par l'avant du dispositif électronique modulaire, sur une section d'entrée des canaux 18 (non représentée). Il peut optionnellement y avoir en plus un ou des ventilateurs positionnés à l'avant de cette section d'entrée des canaux. Cette section 16 peut correspondre à la surface opérationnelle d'un ventilateur de section carrée ou circulaire, de dimension entre 40 et 60 mm (à titre d'exemple et de manière non limitative). Le générateur de flux d'air peut donc être un ventilateur, mais peut également être la pressurisation pour un dispositif embarqué dans un avion, ou bien l'air ambiant pour un véhicule en mouvement créant ainsi un flux d'air de par sa vitesse de déplacement).

Dans un mode particulier de réalisation de l'invention, la pluralité de premières ailettes 17 s'étend depuis la première pièce thermiquement conductrice 14 selon une deuxième direction Z sécante au premier plan 13, comme cela est représenté sur la figure 1. Dans un autre mode de réalisation de l'invention, la pièce thermiquement conductrice 14 peut prendre la forme d'un caloduc présentant, à distance du composant 12, un coude à 90° orienté selon la deuxième direction Z face à la section utile 16, et les ailettes peuvent être empilées horizontalement autour de la partie verticale du caloduc. Plus généralement, l'angle du coude peut prendre toute autre valeur d'angle. De même, l'angle entre l'orientation du coude et les ailettes peut différer de 90°. En outre, les ailettes peuvent être plates ou non plates. Elles sont configurées pour former un canal de passage d'air de section suffisante pour laisser passer l'air sans trop de résistance, pour présenter une surface d'échange avec l'air suffisamment grande et dont la forme engendre localement un écoulement d'air favorisant l'échange de chaleur entre les ailettes et l'air.

Dans les applications traditionnelles, les calories générées par le composant chaud sont, au final, essentiellement réparties dans l'air entourant les équipements. Certaines peuvent être rayonnées, mais c'est une petite partie pour la plupart des environnements standards. Plus on est proche du composant chaud, plus on expulse les calories en nombre dans l'air, de sorte à éviter les chutes de température dans le chemin thermique conducteur. Cependant, répartir efficacement les calories dans l'air nécessite de grandes surfaces de contact et une circulation d'air suffisante. Cela n'est pas garanti par les solutions de l'art antérieur. L'invention, quant à elle, maximise le flux d'air possible en autorisant un canal d'air, avantageusement rectiligne, et préférentiellement de grande section, indépendamment de la hauteur des composants électroniques sur la carte, et indépendamment du modèle de carte. En outre, la hauteur disponible pour le canal d'air est bien supérieure à la hauteur possible au-dessus du point chaud d'un dispositif de refroidissement traditionnel direct à air car la hauteur du point chaud, la hauteur du circuit imprimé, la hauteur des composants sous le circuit imprimé, la marge pour ne pas toucher les cartes adjacentes, la hauteur de l'embase du radiateur du point chaud et les incertitudes de toutes ces dimensions ne sont pas à prendre à compte.

On peut noter que les canaux 18 sont formés par les ailettes 17 et sont avantageusement rectilignes. Toutefois, les ailettes 17, et donc les canaux 18, peuvent être de formes variées permettant un échange thermique entre les ailettes et l'air sans opposer de grande résistance au passage d'air dans le canal 18.

Dans une variante de l'invention, les ailettes 17 et la pièce thermiquement conductrice 14 forment une seule et même pièce. En d'autres termes, dans cette variante, la pièce thermiquement conductrice comprend des protubérances qui forment les ailettes 17. Dans une autre variante, la pièce thermique conductrice 14 et/ou les ailettes 17 peuvent être formées par des caloducs circulaires ou plats, ou bien des « vapor chambers » (chambres à vapeur). Les ailettes peuvent éventuellement être à l'horizontale, empilées parallèlement, par exemple quand les extrémités de la pièce thermiquement conductrice 14 possèdent un coude vers le haut et/ou vers le bas.

Le dispositif électronique modulaire 10 peut comprendre un drain thermique 21. Dans ce cas, la première carte électronique 11 est disposée sous le drain thermique 21, lequel est ajouré au niveau du ou des points chauds 12 pour garder un contact thermique direct entre la pièce conductrice 14 et les points chauds 12. Outre sa fonction de conduction thermique, y compris pour les autres composants de la carte, le drain thermique constitue une pièce mécanique rigide pour le dispositif électronique modulaire. Une opération d'appairage de la carte électronique 11 munie du drain thermique 21, avec la pièce conductrice 14, consiste en la fixation au drain (calage, vissage ou collage), des extrémités latérales de la pièce 14. Cela est rendu nécessaire si l'on veut renforcer la tenue mécanique de l'ensemble. La carte est fixée au drain typiquement aux quatre coins de la carte. La pièce thermiquement conductrice est appuyée sur le point chaud par quatre vis autour du composant chaud, avec ou sans ressorts pour imposer la hauteur et orientation de la pièce conductrice. Puis la pièce conductrice ainsi en place est stabilisée avec de la colle, des cales, ou des vis/écrous de réglage de hauteur avec le drain aux extrémités le long des glissières. Le drain est situé entre la carte et la pièce conductrice. Typiquement, la pièce thermiquement conductrice est vissée à l'aide de trous autour du composant chaud, en laissant la pièce thermiquement conductrice prendre la coplanarité et la hauteur exacte imposée par le composant chaud assemblé sur la carte électronique. Puis cet état est figé par de la colle, ou des vis, ou des vis/écrous collées entre la pièce thermiquement conductrice et le drain thermique qui est lui-même destiné à être fixé de façon rigide et sans tolérance dans les glissières des paniers à carte (comme cela sera expliqué ci-dessous). Cela permet d'apparier et de compenser les tolérances propres à chaque exemplaire de carte (pour éviter les problèmes de résistance aux chocs/vibrations du système relativement à la pièce thermiquement conductrice avec ses radiateurs aux extrémités près des glissières), tout en conservant un ensemble modulaire amovible. L'invention permet donc de compenser les tolérances sans pénaliser la performance thermique du dispositif électronique modulaire. On peut noter ici que si le composant chaud est au-dessus de la carte, la pièce conductrice 14 sera dessus. Si le composant chaud est au-dessous de la carte, la pièce conductrice sera dessous. Le drain est la plupart du temps préférentiellement entre le point chaud et la pièce conductrice (drain ajouré au niveau du point chaud), mais il peut aussi être coplanaire de la pièce conductrice, voire même en dessous le PCB. Si le point chaud est situé sous le PCB, c'est le contraire.

Dans l'art antérieur, avec un système classique de refroidissement par conduction thermique, cette compensation des tolérances n'est pas possible car les ailettes, généralement horizontales, sont situées de l'autre côté de la paroi formée par les murs froids incluant les glissières.

On peut également noter que le composant chaud n'est pas nécessairement soudé, il peut également être sur un support de circuit intégré, ce qui ne change rien à la problématique de tolérance de hauteur et coplanarité du support, tolérance d'épaisseur du support et du composant chaud, et à la solution apportée par l'invention.

En outre, la phase d'appariement décrite ci-dessus reste optionnelle dans le cadre de l'invention. On peut notamment s'en passer, par exemple dans le cas où la pièce thermiquement conductrice est assez flexible, et elle est d'autant plus flexible éventuellement que sa longueur est grande grâce à l'invention (comme cela est illustré sur la figure 1). On peut aussi se passer de l'appariement si les chocs/vibrations à supporter par le système complet sont faibles, malgré le porte-à-faux aux extrémités de la pièce thermiquement conductrice. Mais pour les composants chauds à forte dissipation thermique, et quand on ne peut pas accepter le porte-à-faux créé à cause d'un environnement chocs/vibrations assez fort, le diamètre ou la section de la pièce thermiquement conductrice est avantageusement important, et donc la pièce thermiquement conductrice est assez ou très rigide : c'est là qu'on peut la coller/visser/caler aux extrémités du drain en faisant l'appairage.

Autrement dit, dans certaines situations, avec des tolérances non négligeables sur la hauteur du composant 12, l'invention permet de compenser la tolérance par une pièce flexible hautement conductrice 14 telle qu'un caloduc plat, par exemple, ou bien de propager l'incertitude de hauteur et de coplanarité à travers une pièce rigide hautement conductrice et figer la hauteur de l'extrémité recevant les ailettes avec de la colle, des cales ou des vis/écrous ajustables fixés au cadre (drain thermique 21). Dans ce dernier cas, les éléments 14, 11 et 21 (pièce conductrice, carte et drain) s'associent. Une telle possibilité n'est pas permise par un drain thermique de refroidissement par conduction traditionnelle avec un verrou en coin fixé dans la paroi froide, et un écoulement des calories à travers cette paroi froide.

Le dispositif 20 comprend en outre un panier à carte(s) 22 solidaire du châssis et comprenant au moins une glissière 23 guide-cartes (visible sur la figure 2). Dans le dispositif selon l'invention, il peut y avoir une seule carte et une seule glissière, mais aussi plusieurs cartes et plusieurs glissières. Le dispositif électronique modulaire comprend une pièce mécanique ayant une extrémité insérée dans la au moins une glissière 23 guide-cartes du panier à cartes 22, la pièce mécanique étant la première pièce thermiquement conductrice 14 ou le drain thermique 21 disposé sur la première carte électronique 11.

La figure 2 représente schématiquement un mode de réalisation d'un dispositif électronique modulaire 20 selon l'invention. Le dispositif 20 comprend donc le panier à cartes 22 solidaire du châssis, avec au moins une glissière 23 guide-cartes. Dans une variante de l'invention, une extrémité de la première pièce thermiquement conductrice 14 peut être insérée dans la au moins une glissière 23 guide-cartes du panier à cartes 22.

Dans une autre variante de l'invention, le dispositif 20 comprend un drain thermique 21, comme expliqué ci-dessus. Le dispositif 20 comprend donc le panier à cartes 22 solidaire du châssis et comprenant au moins une glissière 23 guide-cartes. La première carte électronique 11 est disposée sous le drain thermique 21, le drain thermique 21 ayant une extrémité insérée dans la au moins une glissière 23 guide-cartes du panier à cartes 22. La pièce mécanique (pièce thermiquement conductrice ou drain thermique) apporte la rigidité nécessaire pour supporter la carte et pour maintenir l'ensemble dans le panier à cartes 22.

La première carte électronique 11 comprend communément des connecteurs 24 de face avant et des connecteurs 27 en face arrière. Le dispositif électronique modulaire comprend avantageusement un fond de panier 25 comprenant des connecteurs 26 aptes à coopérer avec les connecteurs 27 de la première carte électronique 11. Et la section utile 16 de passage d'air est disposée entre le panier à cartes 22 et le fond de panier 25.

Dans le domaine de l'électronique embarquée, il existe communément plusieurs formats de carte électronique, dénommés 3U, 6U, 9U, etc. Le format 3U a une largeur de 100 mm, alors que le format 6U a une largeur de 233,35 mm. Dans ce qui suit, l'invention est illustrée, de manière non-limitative, avec des éléments de format 3U et 6U mais il est aussi possible de considérer des éléments de format 6U (cartes) et 9U (panier à cartes), etc. A la lecture de la description de l'invention, un Homme du métier saura comment adapter l'invention selon les formats de carte à considérer.

Dans le mode de réalisation du dispositif électronique modulaire 20 illustré sur la figure 2, la première carte 11 peut par exemple être de format 3U et le panier à cartes 22 et le drain thermique 21 de format 6U. Le fond de panier 3U 25 permet l'interconnexion des cartes électroniques. La pièce thermiquement conductrice 14 et le drain thermique 21 sont disposés de sorte à s'insérer dans les glissières 23 des paniers à carte 22 de part et d'autre de la carte 11. Grâce à cette disposition, les ailettes 17 sont disposées en contact direct avec la pièce thermiquement conductrice 14, et à distance du composant chaud 12. Un premier avantage est la place disponible pour les ailettes 17, plus importante en périphérie du dispositif 20. Les ailettes 17 occupent donc une plus grande place, c'est-à-dire que la surface de contact entre les ailettes 17 et la pièce 14 est importante. Il en résulte par ailleurs une plus grande surface de contact entre les ailettes 17 et l'air dans les canaux de passage 18, offrant ainsi un meilleur échange thermique pour évacuer les calories issues du composant 12. L'utilisation d'une pièce thermiquement conductrice (ou une chambre à vapeur ou des caloducs ronds ou plats) permet de répartir la chaleur sur la surface de la carte 3U. Comme on le voit sur les figures, la pièce thermiquement conductrice s'étend au-delà de la carte 11. L'extension de la longueur d'un tel dissipateur de chaleur au-delà de la dimension de la carte 3U n'a quasiment pas d'impact sur les performances du chemin thermique dans le cas d'un dispositif diphasique tel qu'un caloduc ou une chambre à vapeur, mais facilite la dissipation de chaleur comme expliqué précédemment.

De plus, la carte 11 étant de format 3U et le drain thermique 21 et les paniers à cartes 22 étant de format 6U, il reste un espace d'environ 133 mm de part et d'autre du fond de panier 25, soit 60 mm de chaque côté. C'est dans cet espace que se trouve la section utile 16 de passage d'air qui est mise à profit pour le refroidissement optimisé. Les canaux de passage 18 débouchent sur cet espace. L'extrémité de sortie des canaux 18 peut coïncider avec le bord du drain thermique 21, mais il est aussi envisageable que les canaux 18 se prolongent davantage, comme ce qui est illustré sur la figure 2. Des ventilateurs efficaces disponibles ont des dimensions de 40 à 60 mm correspondant sensiblement à leur section d'aération. De ce fait, ils peuvent être placés entre le fond de panier et les paniers à cartes, faisant ainsi face aux canaux de passage 18.

Les cartes basse consommation 3U telles que les périphériques peuvent être équipées d'un drain 6U standard, en utilisant les trous de fixation normalisés dans le PCB, et cela est généralement suffisant pour refroidir la carte. Les cartes 6U basse consommation peuvent être combinées avec des cartes 3U haute puissance, en particulier lorsque les cartes 6U sont situées à une extrémité du fond de panier, en tirant parti du panier à cartes 6U existant. Cette combinaison est par exemple assez intéressante lorsque la carte 6U est un switch nécessitant un nombre élevé de contacts sur le fond de panier s'étalant en largeur, et une grande largeur sur la zone des connecteurs avant pour offrir un nombre élevé de prises de câbles réseau, et lorsque les cartes 3U sont des cartes CPU connectées dans une topologie en étoile au commutateur.

L'invention permet également au PCB 3U d'être étendu à une taille de 6U pour héberger des composants de puissance inférieure supplémentaires, lorsque ces composants sont suffisamment plats. C'est le cas des composants DRAM de la mémoire principale qui pourraient être soudés directement sur le PCB principal étendu, sous les ailettes, ou qui pourraient être soudés sur des modules de mémoire standard installés en parallèle sur le PCB principal. Il est également possible d'adjoindre, sur l'un des côtés et à plat, une carte complémentaire telle une carte graphique performante et donc fortement dissipative, disposant de ses propres moyens de circulation d'air ou non. Dans ce cas, l'un des canaux latéraux est utilisé pour refroidir le processeur de la carte 3U, l'autre côté est utilisé pour refroidir la carte d'extension ajoutée.

L'invention assure un refroidissement optimisé des composants chauds de la carte, tout en conservant la modularité des éléments du système dans lequel le dispositif selon l'invention est intégré.

L'invention vient d'être décrite avec une carte 3U et un drain thermique 6U. Toutefois, le même principe s'applique à d'autres formats, par exemple carte 6U et drain thermique 9U.

Grâce à l'invention, le flux d'air pour le refroidissement de la carte électronique se fait naturellement de l'avant vers l'arrière (ou de l'arrière vers l'avant). Cette direction de refroidissement est particulièrement avantageuse au niveau du système complet car elle est compatible avec l'alignement de plusieurs baies (ou dispositifs électroniques modulaires complets) côte-à-côte. Dans l'art antérieur, les dispositifs de refroidissement traditionnels pour les cartes électroniques modulaires comprennent un flux d'air soufflé en parallèle au fond de panier d'un côté de la carte à l'autre, puis éventuellement guidé d'un côté vers l'avant et de l'autre vers l'arrière, au prix d'une perte de charge importante du flux d'air forcé à parcourir un angle de 90°, et avec une perte de place importante à l'intérieur du coffret. Parfois, le panier à carte est pivoté de 90° à l'intérieur du coffret pour éviter les coudes internes sur le flux d'air, mais alors, on perd l'accessibilité directe aux connecteurs informatiques de face avant. D'autres techniques utilisent un drain conducteur pour atteindre les parois froides latérales équipées de guides-cartes, qui sont perpendiculaires au fond de panier, la paroi froide étant refroidie par d'autres moyens extérieurs. Cette interface thermique additionnelle de l'art antérieur constitue une baisse de la performance thermique. De plus dans ce cas, vient s'ajouter une autre perte importante au niveau de l'interface thermique entre la pièce conductrice ou le drain, et le point chaud, liée aux incertitudes de fabrication et d'assemblage de composants en hauteur et en coplanarité.

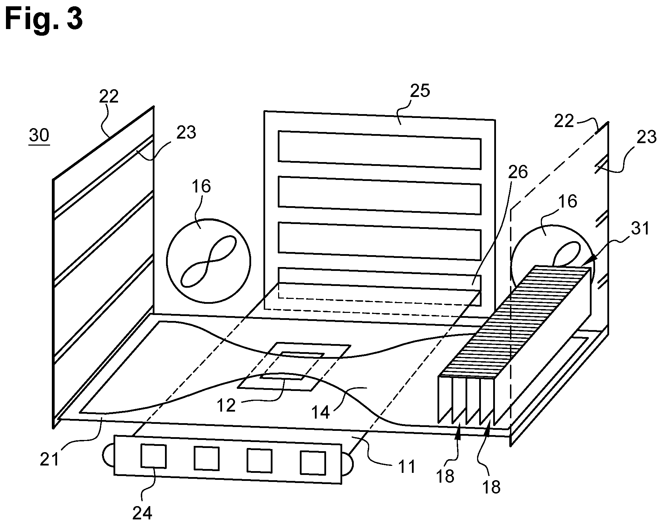

La figure 3 représente schématiquement un autre mode de réalisation d'un dispositif électronique modulaire 30 selon l'invention. Le dispositif électronique modulaire 30 est identique au dispositif électronique modulaire 20 présenté à la figure 2. Le dispositif de refroidissement 15 du dispositif électronique modulaire 30 comprend en outre une plaque 31 disposée sur le au moins un premier canal de passage 18 et sensiblement parallèle au premier plan 13. La plaque 31 vise à fermer le ou les canaux de passage 18 et peut être partie intégrante des ailettes 17.

On peut noter que les ailettes 17 peuvent être situées sur la surface supérieure (ou inférieure) uniquement, ou à la fois sur la surface supérieure et la surface inférieure. Dans le premier cas, le sommet des ailettes peut être fermé par la plaque 31 pour former un canal de passage 18 hermétique. Dans le second cas, avec à la fois des ailettes supérieures et inférieures, les positions des ailettes inférieures peuvent être décalées pour s'entrelacer avec celles de la carte voisine et former un canal de passage fermé avec une densité d'ailettes plus élevée et un canal de passage de section carrée typique au pas naturel de la carte. L'herméticité du canal ainsi constitué peut nécessiter de munir les ailettes extérieures d'un joint sur la longueur des ailettes. Avoir un canal d'air hermétique est très intéressant pour éviter que des contaminants potentiels dans l'air (poussières, vapeurs, brouillard salin, ...) ne soient en contact avec les composants électroniques. Cela permet également d'utiliser la totalité du flux d'air disponible pour refroidir les parois ou ailettes.

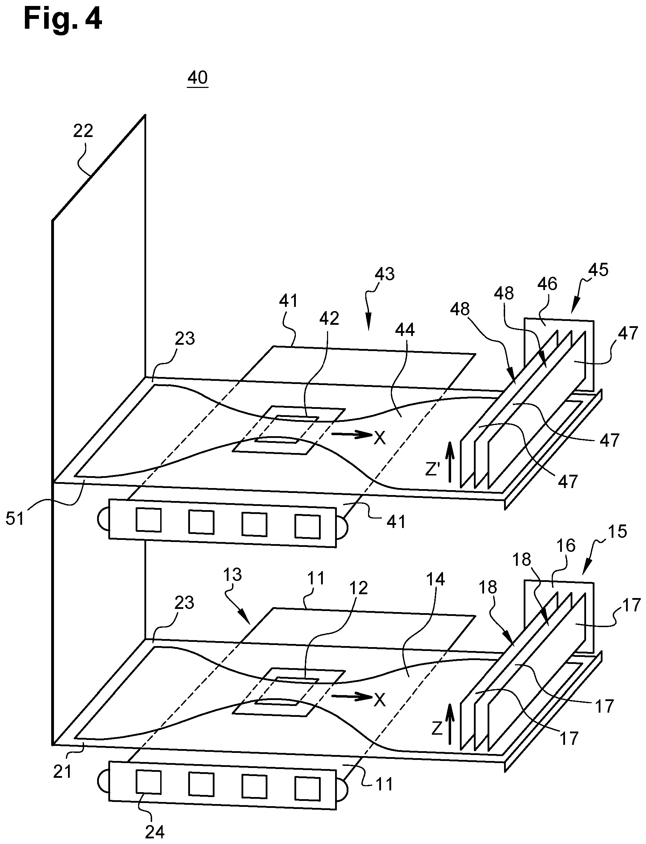

La figure 4 représente schématiquement un autre mode de réalisation d'un dispositif électronique modulaire 40 selon l'invention. Dans ce mode de réalisation, le dispositif électronique modulaire 40 comprend en outre une deuxième carte électronique 41 reliée au châssis et portant au moins un deuxième composant 42 délivrant de la chaleur, ladite deuxième carte électronique 41 s'étendant selon un deuxième plan 43 sensiblement parallèle au premier plan 13. Le dispositif 40 comprend une deuxième pièce thermiquement conductrice 44 disposée sur la deuxième carte électronique 41 sensiblement parallèlement au deuxième plan 43 et s'étendant depuis le au moins un deuxième composant 42 vers une extrémité, et au-delà de l'extrémité, de la deuxième carte électronique 41 selon une troisième direction principale sensiblement parallèle à la première direction principale X. Enfin, le dispositif 40 comprend un deuxième dispositif de refroidissement 45 de la deuxième carte électronique, ledit deuxième dispositif de refroidissement 45 comprenant une pluralité de deuxièmes ailettes 47 thermiquement conductrices disposées à distance du au moins un deuxième composant 42, la pluralité de deuxièmes ailettes 47 formant, entre deux ailettes adjacentes, au moins un deuxième canal de passage 48 débouchant vers une deuxième section utile 46 de passage d'air.

Comme déjà expliqué précédemment, dans un mode particulier de réalisation de l'invention, la pluralité de deuxièmes ailettes 47 s'étend depuis la première pièce thermiquement conductrice 44 selon une deuxième direction Z' sécante au premier plan 13. Dans un autre mode de réalisation de l'invention, la pièce thermiquement conductrice 44 peut prendre la forme d'un caloduc présentant, à distance du composant 12, un coude à 90° orienté selon la deuxième direction Z' face à la section utile 46, et les ailettes peuvent être empilées horizontalement autour de la partie verticale du caloduc.

En d'autres termes, nous sommes en présence d'un dispositif électronique modulaire présentant deux cartes électroniques 11, 41, chacun avec un dispositif de refroidissement 15, 45. Comme évoqué ci-dessous, les ailettes 17, respectivement 47, sont en contact direct avec la pièce thermiquement conductrice de la carte 11, respectivement 41. L'ensemble pièce conductrice et ailettes peut être sur la carte électronique ou sous la carte électronique, bien que préférentiellement du même côté que le point chaud.

La hauteur du canal d'air est maximisée et peut être égale au pas de la carte (ou multiple du pas de la carte) moins l'épaisseur du drain thermique dans cette zone. Avec un dispositif traditionnel, la hauteur du canal d'air est limitée en plus par l'épaisseur du PCB, par la hauteur du composant sur le dessus de la carte, par la partie du pas de la carte allouée à la face inférieure et par la hauteur des composants sur le bas.

De plus, un flux d'air laminaire peut être obtenu avec le dispositif de l'invention tandis que des turbulences sont créées avec un dispositif traditionnel par différentes hauteurs de composants. Pour une même capacité de ventilation et une même consommation d'énergie, le débit d'air est beaucoup plus élevé avec l'invention, la fiabilité et la longévité du ventilateur sont meilleures, et le bruit acoustique induit dans l'air est plus faible.

Les ailettes peuvent avoir une double densité ou plus, au cas où la carte voisine ne dissipe pas beaucoup de puissance et n'est pas équipée de ailettes. La densité des ailettes de chaque emplacement peut être optimisée en fonction de la dissipation de puissance de chaque carte. Dans un refroidissement traditionnel des cartes modulaires existantes disposées avec un pas inter-carte fixe, il n'est pas possible de bénéficier de la moindre dissipation de puissance des cartes voisines. L'avantage de l'invention réside dans le fait que la hauteur utile dédiée au refroidissement est maximisée. Les ailettes 17, 47 sont situées à un endroit où il n'y a pas de composants. Toute la hauteur disponible entre deux cartes est disponible pour les ailettes.

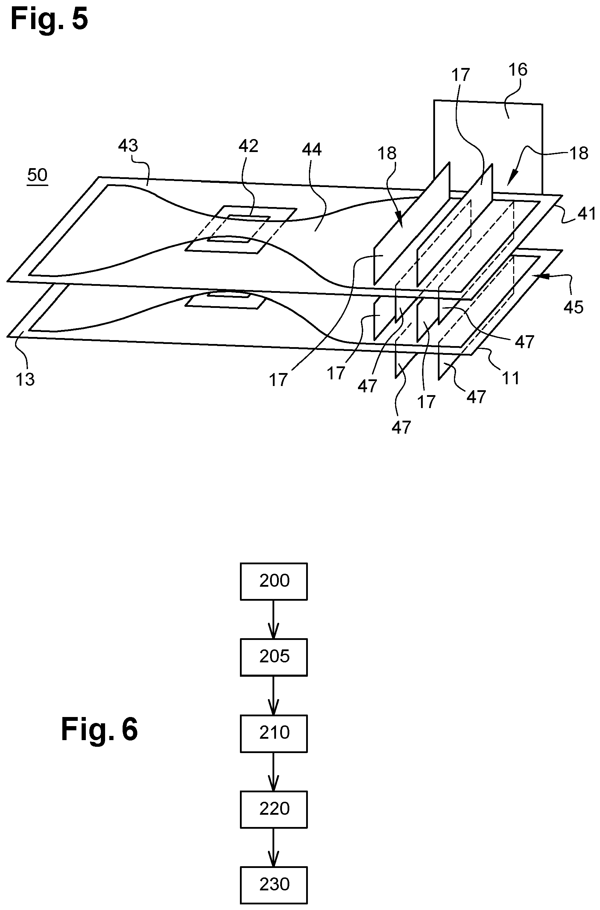

La figure 5 représente schématiquement une portion du dispositif de refroidissement 45 selon un autre mode de réalisation du dispositif électronique modulaire 50 selon l'invention. Dans ce mode de réalisation, une ailette de la pluralité de premières ailettes 17 est disposée entre deux ailettes de la pluralité de deuxièmes ailettes 47, et la deuxième section utile 46 de passage d'air est la première section utile 16 de passage d'air. Autrement dit, dans ce mode de réalisation, les ailettes 47 sont situées sous la carte 41 et les ailettes 17 sont situées sur la carte 11, adjacente dans la hauteur à la carte 41. Les ailettes respectives des ailettes 17 et 47 sont adaptables de sorte à former des canaux de passage entre les deux cartes 11, 41 complètement hermétiques. Dans ce mode de réalisation, les ailettes 17 de la carte inférieure 11 et les ailettes 47 de la carte supérieure 41 sont entrelacées. Dans ce mode, chaque carte est équipée d'ailettes de hauteur s'étendant moitié sur le dessus et sur le dessous de la carte. Les ailettes du dessous sont décalées d'un demi-pas d'ailettes par rapport aux ailettes du dessus. Sur la figure 5, dans un souci de visibilité, sont représentées les ailettes du dessus et du dessous de la carte supérieure 41. Les ailettes de la carte inférieure 11 sont identiques à celles de la carte supérieure 41. Enfin, sur cette représentation, les cartes 11 et 41 ne sont pas dans leur position opérationnelle. Une fois mises en place dans les glissières du panier à cartes, dans leur position opérationnelle, les ailettes 47 de dessous de la carte supérieure 41 viennent à proximité immédiate de la surface supérieure (c'est-à-dire de la pièce thermiquement conductrice) de la carte inférieure 11 et les ailettes 17 de dessus de la carte inférieure 11 viennent à proximité immédiate de la surface inférieure du drain de la carte supérieure 41.

Il est également possible d'équiper les cartes des slots impairs uniquement avec des ailettes supérieures de hauteur presque égale à 2 slots, et les cartes des slots pairs uniquement avec des ailettes inférieures de hauteur presque égale à 2 slots et décalées d'un demi pas d'ailettes. On obtient ainsi un canal d'air de section carrée typique de 40 x 40 mm² pour un pas inter-slot typique de 1 inch, soit 2,54 cm, pouvant faire face à un ventilateur standard 40 x 40 mm². Un autre mode de réalisation consisterait à n'équiper chacune des 2 cartes que d'ailettes supérieures de hauteur 2 slots, mais de décaler d'un demi pas d'ailette les ailettes du canal de droite, et de retourner la carte supérieure pour obtenir un effet d'entrelacement des ailettes et un canal d'air de section carrée.

Dans une façon complémentaire d'implémenter l'invention, un tel couple de deux cartes typiquement 3U, maintenu solidaire par ses parois et glissières d'une largeur un peu inférieure à 6U cette fois, et formant un ensemble mécanique unique, pourrait à son tour être glissé dans un châssis accueillant des cartes standard 6U avec des glissières standard 6U. Le même principe est applicable à d'autres formats, par exemple pour des cartes 6U et parois au format 9U.

Avantageusement, chaque canal de passage 18, 48 formant une section de sortie, et le dispositif de refroidissement 15, 45 comprend un joint d'étanchéité entre la section de sortie et la section utile 16, 46 de passage d'air. Le canal de passage d'air selon l'invention est facilement scellé, forçant l'air à aller et à rester dans le canal. Le joint d'étanchéité entre le(s) ventilateur(s) fixe(s) (ou bouches d'aérations fixes si le flux d'air n'est pas généré par les ventilateurs du coffret, sous forme fixe ou sous forme de cassette amovible), et le canal de passage d'air attaché à la carte insérée peut facilement être mis en place, contrairement au canal d'air traditionnel sur une carte modulaire devant supporter l'insertion/extraction parallèlement à la section du canal d'air.

Avantageusement, chaque canal de passage 18, 48 forme une section de sortie et la surface de la section de sortie est sensiblement égale à la section utile 16, 46 de passage d'air qui lui fait face.

La section du canal d'air peut être proche d'un carré ou d'un demi-carré, ce qui est une situation beaucoup plus efficace qu'un rectangle plat pour la même surface comme dans un dispositif de refroidissement par flux d'air traditionnel entre les cartes. Les dimensions typiques dans un ordinateur modulaire à pas de 1 pouce pourraient être une section carrée de canal d'air de 40 x 40 mm² (ou ½ carré de 40 x 20 mm²), une longueur de 160 mm avec l'invention, contre 140 x 12 mm² pour un canal traditionnel de longueur 3U, soit de 100 mm. La surface de l'air en contact avec les ailettes est 50% plus élevée avec le dispositif de l'invention. La section avec le dispositif de l'invention correspond à une section carrée de ventilateur pour 2 slots, ce qui permet de conduire l'air dans le canal sans perte de charge importante qui pourrait entraîner une perte d'efficacité (débit d'air plus lent) et générer un bruit acoustique. Un carré étant la plus grande section rectangulaire avec le périmètre le plus bas, la résistance au flux d'air est optimisée, ainsi que le coût et le poids du matériau définissant le canal, y compris le joint d'étanchéité avec le ventilateur.

La première et/ou deuxième section utile 16, 46 de passage d'air est formée par un générateur de flux d'air, préférentiellement un ventilateur relié au châssis, orienté de sorte à évacuer ou pousser l'air des premiers/deuxièmes canaux de passage 18, 48 vers l'extérieur du dispositif électronique modulaire.

Les ailettes peuvent faire partie des caloducs plats ou de la chambre à vapeur (ou de tout matériau hautement conducteur). En variante, en raison de la grande surface horizontale de contact disponible, elles pourraient se présenter sous la forme de profils de dissipateur thermique traditionnel séparés et fixés mécaniquement avec des moyens traditionnels, notamment en utilisant une fixation à visser avec de la graisse comme interface thermique. Cette alternative permet l'utilisation de profils de dissipateur thermique standard optimisés pour les processeurs de serveur à grand volume de fabrication, et la sélection du meilleur canal d'air en fonction des cartes voisines au moment de l'intégration du châssis. Plusieurs dissipateurs de chaleur successifs dans la longueur du canal peuvent être utilisés avec différents espacements d'ailettes: avec un pas plus grand du côté de l'entrée d'air frais, et un pas plus faible du côté de la sortie d'air chaud. De cette manière, la chaleur extraite des canaux dans l'air peut être maintenue plus ou moins constante sur la longueur du canal et la température le long du canal est plus uniforme, plutôt que de s'élever trop vite le long du canal. Plusieurs points chauds d'une même carte peuvent être refroidis par des pièces hautement conductrices rejoignant en parallèle les bords du panier à carte, chaque pièce pouvant accueillir à ses extrémités ses ailettes propres adaptées à la puissance de chaque point chaud.

Il ressort que le dispositif électronique modulaire selon l'invention garantit un refroidissement optimisé des composants chauds de la carte. Il permet de conserver la modularité des éléments du système dans lequel le dispositif est intégré. Comme cela ressort clairement des figures et de leur description, il est aisé d'insérer, changer, faire évoluer, réparer tout élément constitutif du dispositif selon l'invention. On peut réaliser une réparation, par exemple par échange de carte, sans devoir débrancher les autres éléments. L'invention garantit une modularité à la fois pour la conception du système mais aussi pour sa maintenance. En outre, le dispositif électronique modulaire est constitué de telle manière à pouvoir « absorber », grâce au positionnement relatif des canaux 18 par rapport au composant chaud ainsi que le montage de la carte par rapport au panier à cartes, les incertitudes sur la hauteur et le parallélisme du ou des composants chauds, sans pénaliser la performance thermique du dispositif.

La figure 6 représente un organigramme possible des étapes d'un procédé d'assemblage d'un dispositif électronique modulaire 10 selon l'invention. Le procédé comprend les étapes suivantes :
- Disposition (étape 200) du drain thermique 21 sur la carte électronique 11, le drain thermique 21 présentant un ajourement apte à recevoir le au moins un composant 12 ;
- Fixation (étape 205) du drain thermique 21 à la périphérie de la carte électronique 11. L'ensemble carte électronique 11 et drain thermique 21 est conçu pour pouvoir être fixé ultérieurement dans des glissières fixes du panier à cartes ;
- Appui (étape 210) de la pièce thermiquement conductrice (14) sur le au moins un premier composant (12) sensiblement parallèlement au premier plan (13), sur le drain thermique (21) ;
- Fixation (étape 220) de la pièce thermique conductrice (14) avec la carte électronique, en des points situés en périphérie du composant chaud à refroidir ;
- Fixation optionnelle (étape 230) près des extrémités latérales de la pièce thermiquement conductrice 14 sur le drain 21 à une hauteur variable imposée par la hauteur et coplanarité du composant chaud 12. Cette hauteur variable peut être prise en compte par un réglage de vis/écrous, par collage et/ou par des cales. La carte électronique munie de son drain se retrouve appariée avec la pièce thermique conductrice. Cela permet de compenser les tolérances propres à chaque exemplaire de carte. Il y a donc fixation rigide tout en conservant l'aspect modulaire de l'invention.

Le drain thermique 21 est ajouré d'une fenêtre au niveau du composant chaud (composant 12) pour laisser le contact direct du composant chaud avec la pièce thermiquement conductrice 14. Comme déjà mentionné plus haut, la carte électronique 11 est fixée au drain thermique 21 en périphérie de la carte. La pièce thermiquement conductrice 14 est appuyée sur le point chaud, avantageusement par quatre vis autour du point chaud, avec ou sans ressorts (les ressorts permettent de contrôler la force d'appui) pour imposer la hauteur et l'orientation de la pièce thermiquement conductrice. Puis la pièce thermiquement conductrice 14 ainsi en place est stabilisée avec un dispositif de réglage (par exemple de la colle, des cales, ou des vis de réglage de hauteur) avec le drain thermique près de ses extrémités proches des glissières. Le drain thermique 21 est situé entre la carte électronique et la pièce thermiquement conductrice 14 ; ou la pièce thermiquement conductrice est située sur le même plan que le drain.

Ainsi, il en résulte un montage de la carte électronique par rapport au panier à cartes qui permet de compenser les incertitudes sur la hauteur et le parallélisme du ou des composants, tout en conservant la modularité de l'ensemble avec un refroidissement optimisé.

Il apparaîtra plus généralement à l'Homme du métier que diverses modifications peuvent être apportées aux modes de réalisation décrits ci-dessus, à la lumière de l'enseignement qui vient de lui être divulgué et en tant que ces variantes sont comprises dans le champ d'application des revendications annexées.

Le dispositif peut être utilisé dans toutes les rotations possibles de l'espace. En particulier, les cartes peuvent être disposées à la verticale, les connecteurs informatiques utilisateur toujours à l'avant, et les deux couloirs d'air latéraux en haut et bas. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'Homme du métier se basant sur ses connaissances générales.

## Revendications

1. Dispositif électronique modulaire (10, 20, 30, 40, 50) comprenant :
- un châssis ;
- une première carte électronique (11) reliée au châssis et portant au moins un premier composant (12) destiné à délivrer de la chaleur, ladite première carte électronique (11) s'étendant selon un premier plan (13) ;
- une première pièce thermiquement conductrice (14) disposée sur la première carte électronique (11) sensiblement parallèlement au premier plan (13) et s'étendant depuis le au moins un premier composant (12) au-delà d'une extrémité de la première carte électronique (11) selon une première direction principale (X) ;
- un premier dispositif de refroidissement (15) de la première carte électronique (11) ;
- un panier à carte(s) (22) solidaire du châssis et comprenant au moins une glissière (23) guide-cartes ;
le dispositif électronique modulaire étant **caractérisé en ce que** le premier dispositif de refroidissement (15) comprend :
- une première section utile (16) de passage d'air ;
- une pluralité de premières ailettes (17) thermiquement conductrices disposées à distance du au moins un premier composant (12), la pluralité de premières ailettes (17) formant, entre deux ailettes adjacentes, au moins un premier canal de passage (18) débouchant vers la première section utile (16) de passage d'air,
et **en ce que** le dispositif électronique modulaire comprend une pièce mécanique ayant une extrémité insérée dans la au moins une glissière (23) guide-cartes du panier à carte(s) (22), la pièce mécanique étant la première pièce thermiquement conductrice (14) ou un drain thermique (21) disposé sur la première carte électronique (11) ;
le premier dispositif de refroidissement (15) étant placé à la périphérie de la première pièce thermiquement conductrice (14), au-delà de la première carte électronique (11).

2. Dispositif électronique modulaire (20, 30, 40, 50) selon la revendication 1, dans lequel la première carte électronique (11) comprend des connecteurs (27) en face arrière, le dispositif électronique modulaire comprenant en outre un fond de panier (25) comprenant des connecteurs (26) aptes à coopérer avec les connecteurs (27) en face arrière d'une première carte électronique (11), la section utile (16) de passage d'air étant disposée entre le panier à carte(s) (22) et le fond de panier (25).

3. Dispositif électronique modulaire (30, 40) selon l'une quelconque des revendications 1 ou 2, dans lequel le dispositif de refroidissement (15) comprend une plaque (31) disposée de façon à fermer un ou plusieurs canaux de passage d'air (18).

4. Dispositif électronique modulaire (40, 50) selon l'une quelconque des revendications 1 à 3, comprenant en outre :
- une deuxième carte électronique (41) reliée au châssis et portant au moins un deuxième composant (42) destiné à délivrer de la chaleur, ladite deuxième carte électronique (41) s'étendant selon un deuxième plan (43) sensiblement parallèle au premier plan (13) ;
- une deuxième pièce thermiquement conductrice (44) disposée sur la deuxième carte électronique (41) sensiblement parallèlement au deuxième plan (43) et s'étendant depuis le au moins un deuxième composant (42) au-delà d'une extrémité de la deuxième carte électronique (41) selon une troisième direction principale sensiblement parallèle à la première direction principale (X) ;
- un deuxième dispositif de refroidissement (45) de la deuxième carte électronique ;
ledit deuxième dispositif de refroidissement (45) comprenant une pluralité de deuxièmes ailettes (47) thermiquement conductrices disposées à distance du au moins un deuxième composant (42), la pluralité de deuxièmes ailettes (47) formant, entre deux ailettes adjacentes, au moins un deuxième canal de passage (48) débouchant vers une deuxième section utile (46) de passage d'air.

5. Dispositif électronique modulaire (50) selon la revendication 4, dans lequel une ailette de la pluralité de premières ailettes (17) est disposée entre deux ailettes de la pluralité de deuxièmes ailettes (47), et la deuxième section utile (46) de passage d'air est la première section utile (16) de passage d'air.

6. Dispositif électronique modulaire (10, 20, 30, 40, 50) selon l'une quelconque des revendications 1 à 5, dans lequel chaque canal de passage (18, 48) forme une section de sortie et la surface de la section de sortie est sensiblement égale à la section utile (16, 46) de passage d'air qui lui fait face.

7. Dispositif électronique modulaire (10, 20, 30, 40, 50) selon l'une quelconque des revendications 1 à 6, dans lequel la première et/ou deuxième section utile (16, 46) de passage d'air est formée par un générateur de flux d'air, préférentiellement un ventilateur relié au châssis, orienté de sorte à évacuer l'air des premiers/deuxièmes canaux de passage (18, 48) vers l'extérieur du dispositif électronique modulaire.

8. Dispositif électronique modulaire (10, 20, 30, 40, 50) selon l'une quelconque des revendications 1 à 7, chaque canal de passage (18, 48) formant une section de sortie, dans lequel le dispositif de refroidissement (15, 45) comprend un joint d'étanchéité entre la section de sortie et la section utile (16, 46) de passage d'air.

9. Procédé d'assemblage d'un dispositif électronique modulaire (10, 20, 30, 40, 50) selon l'une quelconque des revendications 1 à 8, comprenant les étapes suivantes :
- Disposition (200) du drain thermique (21) sur la carte électronique, le drain thermique (21) présentant un ajourement apte à recevoir le au moins un composant (12) ;
- Fixation (étape 205) du drain thermique (21) à la périphérie de la carte électronique (11) ;
- Appui (210) de la pièce thermiquement conductrice (14) sur le au moins un premier composant (12) sensiblement parallèlement au premier plan (13), sur le drain thermique (21) ;
- Fixation (220) de la pièce thermiquement conductrice (14) avec la carte électronique (11), en des points situés en périphérie du au moins un premier composant (12) ;
- Fixer l'ensemble formé par la carte électronique (11) et le drain thermique (21) au panier à cartes par insertion du drain thermique (21) ou de la pièce thermiquement conductrice (14) dans des glissières fixes du panier à cartes.

## Patentansprüche

1. Modulare elektronische Vorrichtung (10, 20, 30, 40, 50), umfassend:
- einen Rahmen;
- eine erste elektronische Karte (11), die mit dem Rahmen verbunden ist und mindestens eine erste Komponente (12) trägt, die dazu bestimmt ist, Wärme abzugeben, wobei sich die erste elektronische Karte (11) in einer ersten Ebene (13) erstreckt;
- ein erstes wärmeleitendes Stück (14), das auf der ersten elektronischen Karte (11) im Wesentlichen parallel zur ersten Ebene (13) angeordnet ist und sich von der mindestens einen ersten Komponente (12) jenseits einem Ende der ersten elektronischen Karte (11) hinaus in einer ersten Hauptrichtung (X) erstreckt;
- eine erste Kühlvorrichtung (15) der ersten elektronischen Karte (11);
- einen Kartenträger (22), der fest mit dem Rahmen verbunden ist und mindestens eine Kartenführungsschiene (23) umfasst;
wobei die modulare elektronische Vorrichtung **dadurch gekennzeichnet ist, dass** die erste Kühlvorrichtung (15) umfasst:
- einen ersten nutzbaren Luftdurchgangsabschnitt (16);
- eine Vielzahl von ersten wärmeleitenden Lamellen (17), die in einem Abstand zu der mindestens einen ersten Komponente (12) angeordnet sind, wobei die Vielzahl von ersten Lamellen (17) zwischen zwei angrenzenden Lamellen mindestens einen ersten Durchgangskanal (18) bildet, der in den ersten nutzbaren Luftdurchgangsabschnitt (16) mündet,
und dass die modulare elektronische Vorrichtung ein mechanisches Stück umfasst, dessen eines Ende in die mindestens eine Kartenführungsschiene (23) des Kartenträgers (22) eingeführt ist, wobei das mechanische Stück das erste wärmeleitende Stück (14) oder eine auf der ersten elektronischen Karte (11) angeordnete Wärmesenke (21) ist;
wobei die erste Kühlvorrichtung (15) am Rand des ersten wärmeleitenden Stück (14) jenseits der ersten elektronischen Karte (11) angeordnet ist.

2. Modulare elektronische Vorrichtung (20, 30, 40, 50) nach Anspruch 1, wobei die erste elektronische Karte (11) rückseitige Verbinder (27) umfasst, wobei die modulare elektronische Vorrichtung weiter einen Trägerboden (25) umfasst, der Verbinder (26) umfasst, die zum Zusammenwirken mit den rückseitigen Verbindern (27) einer ersten elektronischen Karte (11) geeignet sind, wobei der nutzbare Luftdurchgangsabschnitt (16) zwischen dem Kartenträger (22) und dem Trägerboden (25) angeordnet ist.

3. Modulare elektronische Vorrichtung (30, 40) nach einem der Ansprüche 1 oder 2, wobei die Kühlvorrichtung (15) eine Platte (31) umfasst, die derart angeordnet ist, dass sie einen oder mehrere Luftdurchgangskanäle (18) verschließt.

4. Modulare elektronische Vorrichtung (40, 50) nach einem der Ansprüche 1 bis 3, weiter umfassend:
- eine zweite elektronische Karte (41), die mit dem Rahmen verbunden ist und mindestens eine zweite Komponente (42) trägt, die dazu bestimmt ist, Wärme abzugeben, wobei sich die zweite elektronische Karte (41) in einer zweiten Ebene (43) erstreckt, die im Wesentlichen parallel zur ersten Ebene (13) verläuft;
- ein zweites Wärmeleitungsstück (44), das auf der zweiten elektronischen Karte (41) im Wesentlichen parallel zur zweiten Ebene (43) angeordnet ist und sich von der mindestens einen zweiten Komponente (42) jenseits einem Ende der zweiten elektronischen Karte (41) in einer dritten Hauptrichtung erstreckt, die im Wesentlichen parallel zur ersten Hauptrichtung (X) verläuft;
- eine zweite Kühlvorrichtung (45) der zweiten elektronischen Karte;
wobei die zweite Kühlvorrichtung (45) eine Vielzahl von zweiten wärmeleitenden Lamellen (47) umfasst, die in einem Abstand zu der mindestens einen zweiten Komponente (42) angeordnet sind, wobei die Vielzahl von zweiten Lamellen (47) zwischen zwei angrenzenden Lamellen mindestens einen zweiten Durchgangskanal (48) bildet, der in einen zweiten nutzbaren Luftdurchgangsabschnitt (46) mündet.

5. Modulare elektronische Vorrichtung (50) nach Anspruch 4, wobei eine Lamelle aus der Vielzahl von ersten Lamellen (17) zwischen zwei Lamellen aus der Vielzahl von zweiten Lamellen (47) angeordnet ist und der zweite nutzbare Luftdurchgangsabschnitt (46) der erste nutzbare Luftdurchgangsabschnitt (16) ist.

6. Modulare elektronische Vorrichtung (10, 20, 30, 40, 50) nach einem der Ansprüche 1 bis 5, wobei jeder Durchgangskanal (18, 48) einen Ausgangsabschnitt bildet und die Fläche des Ausgangsabschnitts im Wesentlichen gleich dem ihm gegenüberliegenden nutzbaren Luftdurchgangsabschnitt (16, 46) ist.

7. Modulare elektronische Vorrichtung (10, 20, 30, 40, 50) nach einem der Ansprüche 1 bis 6, wobei der erste und/oder zweite nutzbare Luftdurchgangsabschnitt (16, 46) durch einen Luftstromgenerator gebildet wird, vorzugsweise durch einen mit dem Rahmen verbundenen Lüfter, der derart ausgerichtet ist, dass er die Luft aus den ersten/ zweiten Durchgangskanälen (18, 48) nach außen aus der modularen elektronischen Vorrichtung ableitet.

8. Modulare elektronische Vorrichtung (10, 20, 30, 40, 50) nach einem der Ansprüche 1 bis 7, wobei jeder Durchgangskanal (18, 48) einen Ausgangsabschnitt bildet, wobei die Kühlvorrichtung (15, 45) eine Dichtung zwischen dem Ausgangsabschnitt und dem nutzbaren Luftdurchgangsabschnitt (16, 46) umfasst.

9. Verfahren zum Zusammenbau einer modularen elektronischen Vorrichtung (10, 20, 30, 40, 50) nach einem der Ansprüche 1 bis 8, umfassend die folgenden Schritte:
- Anordnen (200) der Wärmesenke (21) auf der elektronischen Karte, wobei die Wärmesenke (21) eine Aussparung aufweist, die zur Aufnahme der mindestens einen Komponente (12) geeignet ist;
- Befestigen (Schritt 205) der Wärmesenke (21) am Rand der elektronischen Karte (11);
- Aufbringen (210) des wärmeleitenden Stücks (14) auf der mindestens einen ersten Komponente (12) im Wesentlichen parallel zur ersten Ebene (13) auf der Wärmesenke (21);
- Befestigen (220) des wärmeleitenden Stücks (14) mit der elektronischen Karte (11) an Stellen, die sich am Rand der mindestens einen ersten Komponente (12) befinden;
- Befestigen der durch die elektronische Karte (11) und die Wärmesenke (21) gebildeten Anordnung am Kartenträger, indem die Wärmesenke (21) oder das wärmeleitende Stück (14) in feste Schienen des Kartenträgers eingeführt wird.

## Claims

1. Modular electronic device (10, 20, 30, 40, 50) comprising:
- a frame;
- a first electronic card (11) connected to the frame and bearing at least one first component (12) intended to deliver heat, said first electronic card (11) extending along a first plane (13);
- a first thermally-conducting workpiece (14) arranged on the first electronic card (11) substantially parallel to the first plane (13) and extending from the at least one first component (12) beyond an end of the first electronic card (11) along a first main direction (X);
- a first device (15) for cooling the first electronic card (11);
- a card cage (22) secured to the frame and comprising at least one card-guiding guideway (23);
the modular electronic device being **characterized in that** the first cooling device (15) comprises:
- a first working air-passage cross section (16);
- a plurality of first thermally-conducting fins (17) arranged at a distance from the at least one first component (12), the plurality of first fins (17) forming, between two adjacent fins, at least one first passageway (18) opening onto the first working air-passage cross section (16),
and **in that** the modular electronic device comprises a mechanical part having one end inserted into the at least one card-guiding guideway (23) of the card cage (22), the mechanical workpiece being the first thermally-conducting workpiece (14) or a heat sink (21) arranged on the first electronic card (11);
the first cooling device (15) being placed at the periphery of the first thermally-conducting part (14), beyond the first electronic card (11).

2. Modular electronic device (20, 30, 40, 50) according to claim 1, wherein the first electronic card (11) comprises connectors (27) on the rear face, the modular electronic device further comprising a cage bottom (25) comprising connectors (26) capable of engaging with the connectors (27) on the rear face of a first electronic card (11), the working air-passage cross section (16) being arranged between the card cage (22) and the cage bottom (25).

3. Modular electronic device (30, 40) according to any one of claims 1 or 2, wherein the cooling device (15) comprises a plate (31) arranged so as to close one or more air passageways (18).

4. Modular electronic device (40, 50) according to any one of claims 1 to 3, further comprising:
- a second electronic card (41) connected to the frame and bearing at least one second component (42) intended to deliver heat, said second electronic card (41) extending along a second plane (43) substantially parallel to the first plane (13);
- a second thermally-conducting workpiece (44) arranged on the second electronic card (41) substantially parallel to the second plane (43) and extending from the at least one second component (42) beyond an end of the second electronic card (41) along a third main direction substantially parallel to the first main direction (X);
- a second device (45) for cooling the second electronic card;
said second cooling device (45) comprising a plurality of second thermally-conducting fins (47) arranged at a distance from the at least one second component (42), the plurality of second fins (47) forming, between two adjacent fins, at least one second passageway (48) opening onto a second working air-passage cross section (46).

5. Modular electronic device (50) according to claim 4, wherein a fin of the plurality of first fins (17) is arranged between two fins of the plurality of second fins (47), and the second working air-passage cross section (46) is the first working air-passage cross section (16).

6. Modular electronic device (10, 20, 30, 40, 50) according to any one of claims 1 to 5, wherein each passageway (18, 48) forms an output cross section and the surface of the output cross section is substantially equal to the working air-passage cross section (16, 46) which faces it.

7. Modular electronic device (10, 20, 30, 40, 50) according to any one of claims 1 to 6, wherein the first and/or second working air-passage cross section (16, 46) is formed by an airflow generator, preferably a fan connected to the frame, oriented, so as to discharge air from the first/second passageways (18, 48) towards the outside of the modular electronic device.

8. Modular electronic device (10, 20, 30, 40, 50) according to any one of claims 1 to 7, wherein each passageway (18, 48) forming an output cross section, wherein the cooling device (15, 45) comprises a seal between the output cross section and the working air-passage cross section (16, 46).

9. Method for assembling a modular electronic device (10, 20, 30, 40, 50) according to any one of claims 1 to 8, comprising the following steps:
- Arranging (200) the heat sink (21) on the electronic card, the heat sink (21) having a perforation capable of receiving the at least one component (12);
- Fixing (step 205) the heat sink (21) to the periphery of the electronic card (11);
- Bearing (210) the thermally-conducting workpiece (14) on the at least one first component (12) substantially parallel to the first plane (13), on the heat sink (21);
- Fixing (220) the thermally-conducting workpiece (14) with the electronic card (11), in points located at the periphery of the at least one first component (12);
- Fixing the assembly formed by the electronic card (11) and the heat sink (21) to the card cage by inserting the heat sink (21) or the thermally-conducting workpiece (14) into fixed guideways of the card cage.
